# EUROPEAN PATENT SPECIFICATION

(11) **EP 4 306 914 B1**
(45) Date of publication and mention of the grant of the patent: **11.02.2026**
(21) Application number: 23184704.7
(22) Date of filing: 11.07.2023
(51) Int. Cl.: G01F 23/263, D06F 39/02

(54) **CAPACITIVE SENSOR FOR DETECTING A FLUID LEVEL WITHIN A MOVABLE FLUID TANK OF A DOMESTIC APPLIANCE**
KAPAZITIVER SENSOR ZUR ERFASSUNG EINES FLUIDNIVEAUS IN EINEM BEWEGLICHEN FLUIDTANK EINES HAUSHALTSGERÄTS
CAPTEUR CAPACITIF POUR DÉTECTER UN NIVEAU DE FLUIDE DANS UN RÉSERVOIR DE FLUIDE MOBILE D'UN APPAREIL MÉNAGER

(30) Priority: 14.07.2022 EP 22184942; 20.07.2022 EP 22186119
(43) Date of publication of application: 17.01.2024
(73) Proprietor: Illinois Tool Works Inc., Glenview IL 60025 (US)
(72) Inventor: SCLIP, Marco, Glenview, 60025 (US); BRUNO, Luca, Glenview, 60025 (US); MAINO, Nicola, Glenview, 60025 (US)
(74) Representative: HGF

(56) References cited:
- EP-A1- 2 489 996
- EP-A2- 1 961 575
- DE-A1- 102017 122 722
- DE-A1- 102018 119 166
- IT-A1- UA20 164 395
- US-A- 4 601 201
- US-A1- 2011 106 028

## Description

### Technical Field of Invention

The invention relates to a capacitive sensor for detecting a fluid level within a movable fluid tank of a domestic appliance, for example a detergent tank of a washing machine.

### Background

As household appliances continue to become more sophisticated, the need for modern components increases. Dishwashers, washing machines, ovens, refrigerators, and more are all providing more and more functions to users, many of which are automated. One consequence of this trend is the need of household appliance manufacturers for sophisticated sensing elements within their products to facilitate these automated functions. In the case of water-based devices like dishwashers, embedded liquid level sensors are especially important.

Fluid level sensors are typically designed to detect, measure and regulate levels of a particular free-flowing substance within a contained area, level sensors are predominantly a tool used to monitor liquid levels. They can also be used to monitor solids such as powders. Liquid or fluid level sensors have advanced significantly over the years, and today, a variety of technologies can be used for the process of level measurement, including, for example, float sensors, hydrostatic sensor, radar sensors, ultrasonic sensors radiometric sensors and capacitive sensors.

Capacitive sensors are particularly suitable for heavy duty applications as they are easy to install and highly reliable in a contact or non-contact setup. When used in a non-contact setup, the sensor is simply attached to a (non-conductive) vessel or tank while establishing an electric field that penetrates into the vessel or tank. When there is no fluid in the in the vicinity of the sensor, the sensor will measure a predetermined capacitance (e.g. to a ground). When the fluid level rises into the filed of the sensor, the static capacitance of the sensor is disturbed or changed indicating the presence of a fluid or liquid.

Such sensors usually require a precise setup and arrangement with the fluid tank in order to provide accurate measurement or detection of precise fluid levels during use. Also, for household appliances, it is often the case that fluid tanks or vessels are removed or at least retracted to allow access for filling the tank or vessel (e.g. with detergent or conditioner). These tanks of vessels are repeatedly opened and closed over a long period of time, thus, they have to have a hardwearing and simplistic design that is very easy to use during the lifespan of the appliance. However, available sensors typically require a relatively precise placement or positioning in order to allow for reproducible and reliable measurements. This, in turn, requires mechanisms for the moveable tank or vessel that provide movement with low tolerances, thus increasing complexity and costs.

Document DE 10 2018 119 166 A1, for example, describes a beverage vending machine, including, inter alia, a fluid level measuring device for the water tank. The fluid level measuring device comprises capacitive cells arranged on a printed circuit board (PCB) and an elastomeric film or layer provided between the capacitive cells and the wall of the fluid tank when the fluid measuring device is attached to the fluid tank.

Document DE 10 2017 122 722 A1 describes another beverage vending machine, including, inter alia, a fluid level measuring device for measuring the fluid level of a container. The fluid level measuring device comprises a carrier plate for a printed circuit board (PCB) including linearly arranged capacitive cells. the carrier plate provided with spring elements adapted to bias the fluid level measuring device into contact engagement with the container wall. thin elastomeric layer is provided between the capacitive cells and the container wall.

Therefore, it would be desirable to provide an improved fluid level sensor that is adapted to prevent or at least mitigate the problems associated with the prior art. In particular, it is an object of the present invention to provide a capacitive fluid level sensor for household appliances adapted to determine the fluid level of a removable fluid tank, that is hardwearing and reliable, and has an improved ease of use.

### Summary

According to a first aspect of the present invention, there is provided a capacitive sensor assembly for detecting a fluid level within a removable tank of a domestic appliance along an axis according to claim 1. The assembly is mountable within the domestic appliance, comprising a plurality of fluid level electrodes spaced apart from one another along said axis, wherein each one of the plurality of fluid level electrodes comprises a resiliently deformable contact member adapted to contactingly engage with the removable tank received in the domestic appliance and convey at least one electrical field generated by said capacitive sensor into the removable tank, wherein said resiliently deformable contact member is made from an electrically conductive material adapted to convey said at least one electrical field generated by said capacitive sensor assembly into the removable tank.

This provides the advantage that any possible gaps between the sensor electrodes and the removable tank (once inserted) are avoided, or at least minimised, thus providing an assembly with improved ease of use and wear and tear resistance, as well as, an improved accuracy due to the optimised contact between the inserted tank and the sensor assembly.

Advantageously, said resiliently deformable contact member is made from a material having a relative permittivity adapted to convey said at least one electrical field generated by said capacitive sensor assembly into the removable tank.

Advantageously, the removable tank is slidable in an insertion direction through an opening in the domestic appliance, and wherein the capacitive sensor assembly is mountable opposite to the opening such that said at least one resiliently deformable contact member is directed oppositely to the insertion direction so as to contactingly engage with a wall of the removable tank when inserted.

Advantageously, said resiliently deformable contact member matches the footprint of said at least one fluid level electrode.

In an embodiment not claimed by the invention, the capacitive sensor assembly comprises a single fluid level electrode and wherein said single fluid level electrode extends substantially the height of the fluid tank. This provides the advantage of using one electrode in a continuous fluid level measuring mode so as to allow precise fluid level measurements using one electric field of the capacitive sensor.

Alternatively, said capacitive sensor assembly comprises a plurality of fluid level electrodes arranged so as to form a first row of spaced apart fluid level electrodes along said axis, and a second row of spaced apart fluid level electrodes along said axis parallel to and axially offset from said first row of said spaced apart fluid level electrodes.

This provides the advantage of discrete fluid level measurements, where the precision of the fluid level measurement (resolution) is determined by the number of fluid level electrodes, as well as, the distance between them. Additionally, a combination of continuous measurement and discrete measurement (hybrid) may be applied by measuring the discrete fluid levels when "jumping" from one electrode to the next one, and continuous fluid levels within each one of the fluid electrodes.

Advantageously, said capacitive sensor assembly comprises at least one reference electrode configured for compensating variations in environmental parameters. Advantageously, said capacitive sensor assembly further comprises a housing having an interior configured to receive a printed circuit board (PCB) comprising at least one contact pad operably coupleable with said fluid level electrode. Preferably, said housing comprises a wall with said resiliently deformable contact member mounted to an outside surface of said wall, and wherein said contact pad is operably coupled to said resiliently deformable contact member through said wall.

Alternatively, said housing comprises a wall having at least one aperture, and wherein said resiliently deformable contact member is operably coupled to said at contact pad through said aperture of said wall.

Advantageously, said resiliently deformable contact member comprises any one of: a sponge, for example an electrically conductive sponge, a silicone, for example an electrically conductive silicone, a rubber, for example an electrically conductive rubber, or a thermoplastic elastomer.

Alternatively, said resiliently deformable contact member comprises an electrically conductive spring member. Preferably, said electrically conductive spring member is made from metal.

### Brief Description of Drawings

Example embodiment(s) of the invention are illustrated in the accompanying drawings, in which:
**Figure 1** illustrates a domestic appliance, in particular a washing machine;
**Figure 2** illustrates a fluid tank with attached capacitive sensor assembly (a) an array of discrete fluid electrodes spaced apart and adapted to provide discrete fluid levels in accordance with the number of fluid electrodes, (b) an array of discrete fluid electrodes spaced apart an adapted to provide discrete fluid levels as well as continuous fluid levels within each of the fluid level electrodes, and (c), not encompassed by the wording of the claims, with a single fluid electrode covering the full range of the tank height.
**Figure 3(a)****-(c)** shows an illustration of a side view of the appliance and inserting fluid tank as well as the capacitive sensor assembly having a single full-range fluid electrode, not encompassed by the wording of the claims;
**Figure 4** shows an illustration of (a) an perspective view and (b) a side view of a capacitive sensor assembly with a single full-range fluid electrode and (c) a perspective view of the PCB including electrode pads, not encompassed by the wording of the claims;
**Figure 5** shows an illustration of (a) a perspective view and (b) a side view of a capacitive sensor assembly with a plurality of "hybrid" fluid electrodes;
**Figure 6** shows an illustration of (a) an perspective view and (b) a side view of a capacitive sensor assembly with a plurality of discrete fluid electrodes and (c) a perspective view of the PCB including discrete electrode pads;
**Figure 7** shows an illustration of a perspective view of PCBs, (a) with a "hybrid" fluid electrode pad arrangement and (b) an alternative fluid electrode pad arrangement with two parallelly arranged and offset arrays of fluid electrode pads, and
**Figure 8** shows an illustration of a partial cross-sectional side view of the resiliently deformable contact member (a) attached to the outside of the housing over the fluid electrode pad of the PCB and (b) attached to the electrode pad of the PCB through an aperture of the housing.

### Description

Certain terminology is used in the following description for convenience only and is not limiting. The words 'right', 'left', 'lower', 'upper', 'front', 'rear', 'upward', 'down' and 'downward' designate directions in the drawings to which reference is made and are with respect to the described component when assembled and mounted. The words 'inner', 'inwardly' and 'outer', 'outwardly' refer to directions toward and away from, respectively, a designated centreline or a geometric centre of an element being described (e.g. central axis), the particular meaning being readily apparent from the context of the description. Further, as used herein, the terms 'connected', 'attached', 'coupled', 'mounted' are intended to include direct connections between two members without any other members interposed therebetween, as well as, indirect connections between members in which one or more other members are interposed therebetween. The terminology includes the words specifically mentioned above, derivatives thereof, and words of similar import.

Further, unless otherwise specified, the use of ordinal adjectives, such as, "first", "second", "third" etc. merely indicate that different instances of like objects are being referred to and are not intended to imply that the objects so described must be in a given sequence, either temporally, spatially, in ranking or in any other manner.

Like reference numerals are used to depict like features throughout.

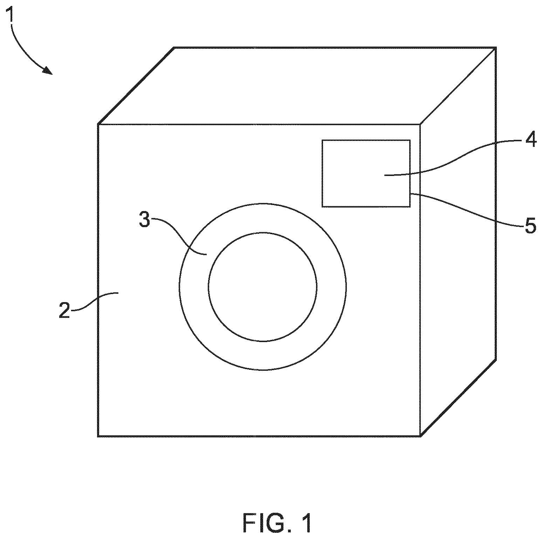

Figure 1 shows a simplified example of a domestic appliance, such as a washing machine 1. The washing machine 1 has a housing 2, a door 3 for loading and unloading and a fluid tank 4 received in an opening 5 in the housing 2. In this particular example, the fluid tank 4 may hold a liquid 7, such as, for example, a fluid detergent or a fluid softener. The fluid tank 4 is movable relative to the housing 2 such that is can be fully removed from the housing 2 or simply pull out of the opening 5 so as to allow filling in the detergent or washing liquid. I.e. the fluid tank 4 may pull out of the housing 2 and be retained in the opening 5 in the manner of a drawer. The fluid tank 4 may be filled by a user. The fluid tank 4 may be latched or otherwise locked in its "closed" position when inserted into the housing 2.

In other examples, the domestic appliance 1 may be a tumble dryer and the fluid tank 4 may hold condensate from the drying process, or any other household appliance that requires a removable fluid tank.

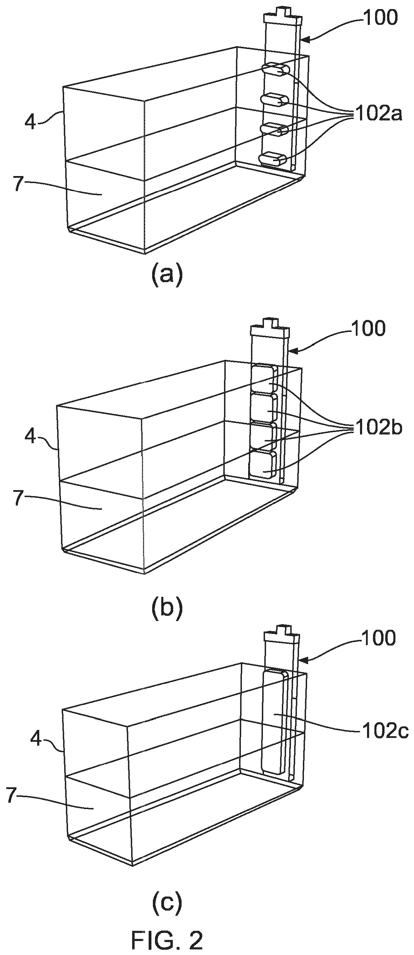

Figures 2 (a) and (b) show perspective illustrations of example embodiments, and figure 2 (c) shows a perspective example not encompassed by the wording of the claims, of a fluid tank 4 with an attached capacitive sensor assembly 100 of the invention, i.e. (a) a sensor assembly 100 with discrete fluid electrodes 102a, (b) a sensor assembly 100 with "hybrid" fluid electrodes 102b (allowing discrete fluid level detection and continuous fluid level detection within each one of the fluid electrodes 102b, and (c) a single full range fluid electrode 102c for continuous fluid level detection.

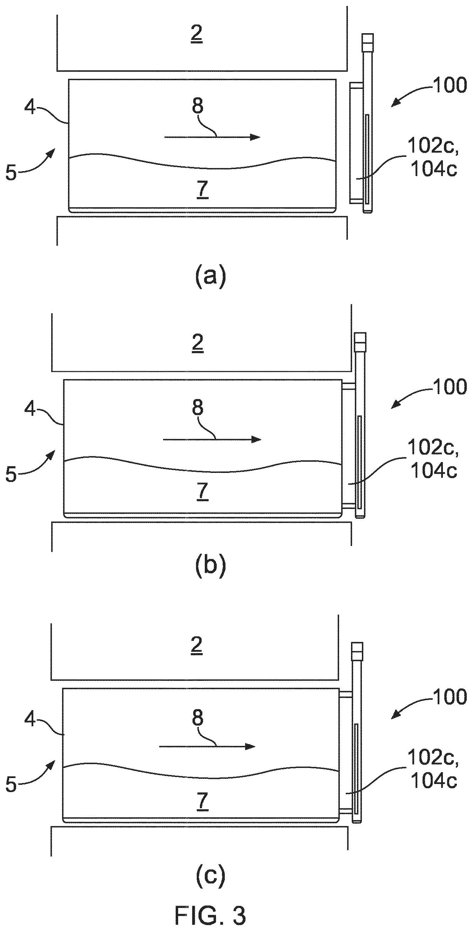

Figures 3 (a) to (c) show side-view illustrations of the fluid tank 4 being moved through the opening 5 and into the housing 2 of the domestic appliance 1, not encompassed by the wording of the claims (see Figure 1). The fluid tank 4 is movable relative to the housing 2 in an insertion direction 8.

As shown, an embodiment (e.g. the single full range fluid electrode 102c of Figure 2 (c)) of the fluid level sensor or capacitive sensor assembly 100 is disposed within the housing 2 of the appliance 1, so as to operably face into the opening 5. The capacitive sensor assembly 100 is configured to detect a current level of the fluid 7 within the fluid tank 4.

In particular, the capacitive sensor assembly 100 of Figure 3 comprises a single electrode 102c including a resiliently deformable contact member or pad 104c operably coupled to the electrode 102c. The resiliently deformable contact member or pad 104c is arranged to contactingly engage an outer wall (rear wall) of the fluid tank 4 (when inserted into the opening 5). When the fluid tank 4 is fully inserted (and latched) into the opening 5, the resiliently deformable contact member or pad 104c is configured to elastically deform so as to prevent (or at least minimise) any air gaps between the resiliently deformable contact member 104c and the outer wall of the fluid tank 4, and thus ensure maximum sensitivity of the fluid electrode(s) 102 when detecting the fluid level of the fluid tank 4.

As illustrated in Figure 3(a), as the fluid tank 4 is initially inserted into the housing 2 the fluid tank 4 is spaced from the resiliently deformable contact member 104c of the capacitive sensor assembly 100. As shown in Figure 3(b), once inserted into the housing 2, the fluid tank 4 contacts the fluid electrode 102c (via the resiliently deformable contact member 104c) of the capacitive sensor assembly 100. As shown in Figure 3(c), contact between the fluid tank 4 and the fluid electrode 102c of the capacitive sensor assembly 100 may deform the resiliently deformable contact member or pad 104c (e.g. once latched or locked into its fully inserted position), and thus reduces or even avoids possible airgaps between the electrode 102c and the fluid tank 4.

In particular, the capacitive sensor assembly 100 measures a capacitance of an electric field generated through the fluid electrode 102 (i.e. any one of the different embodiments 102a, 102b, 102c) (the field is conveyed via its resiliently deformable contact member or pad 104a, 104b, 104c). This electric field is "disturbed" by any object moving into that field, changing the capacitance measured at that particular fluid electrode 102c. Thus, the change of the measured capacitance indicates, for example, a fluid 7 presence at that fluid electrode 102c, allowing the fluid level within the tank 4 to be determined continuously (e.g. when using a full range single fluid electrode 102c) or discretely (e.g. when using relatively narrow spaced apart fluid electrodes 102a, each one indicating a discrete fluid level). Alternatively or additionally, the fluid electrodes 102b may be shaped so as to allow a hybrid measurement, i.e. a discrete fluid level detection when reaching a particular fluid electrode 102b and a continuous fluid level measurement within the range of that particular fluid electrode 102b. Discrete measurements may be made by simply detecting a "disturbance" of the capacitance of a particular fluid electrode 102b, wherein continuous measurements may be made by detecting a change of that capacitance when the fluid rises up or lowers down within the range of the fluid electrode 102b (e.g. calibrating the change to a particular fluid level).

Accordingly, the capacitive sensor assembly 100 can detect a fluid level in the fluid tank 4 without contacting the fluid 7 or having any components within, or attached to, the fluid tank 4.

The resiliently deformable contact member or pad 104 (including any embodiment 104a, 104b, 104c) ensures suitable contact is made with the fluid tank 4 even if the position of the fluid tank 4 varies in the insertion direction 8, for example, due to tolerances or loosening of latches over time. Advantageously, eliminating or reducing air gaps between the capacitive sensor assembly 100 and the fluid tank 4 will improve detection of a changing level of the fluid 7 within the fluid tank 4, because air has an extremely low relative permittivity.

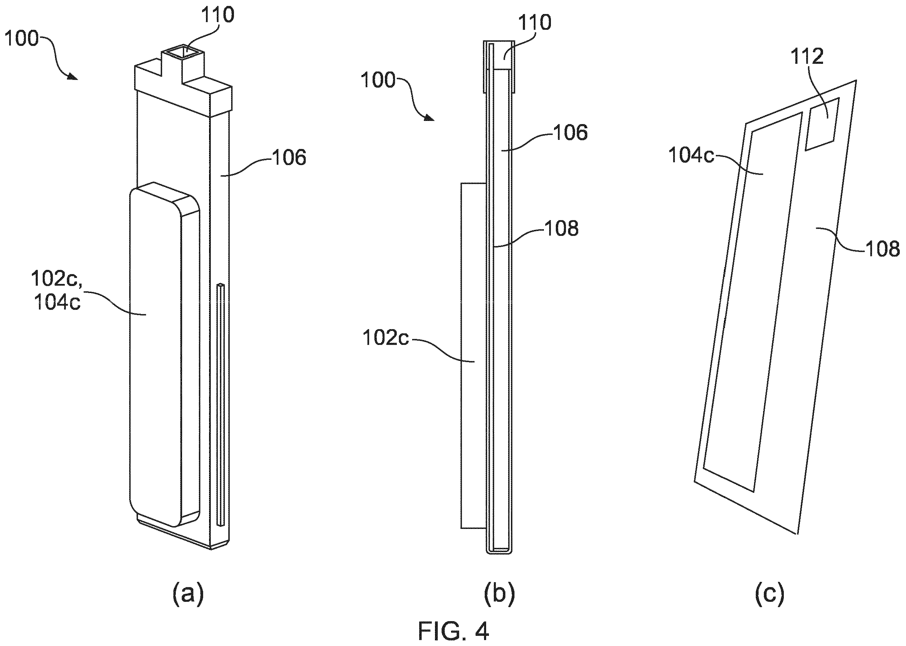

Figures 4 (a) to (c) show a more detailed illustration, not encompassed by the wording of the claims, of the single full-range fluid electrode 102c, (a) in a perspective front view, (b) in a side view and (c) a PCB 108 (printed circuit board) with a full range fluid electrode pad 102c incorporated for engagement with the resiliently deformable contact member 104c. Also, the PCB 108 includes a reference electrode pad 112 or compensatory electrode, suitable for compensating any variations in the environmental parameters, such as, temperature or humidity etc. Also, each example embodiment of the capacitive sensor assembly 100 comprises a housing 106 within which sensor electronics are housed. In particular, the printed circuit board (PCB) 108 is housed within the housing 106. A connector 110 provides an electrical power and communications connection to the sensor electronics.

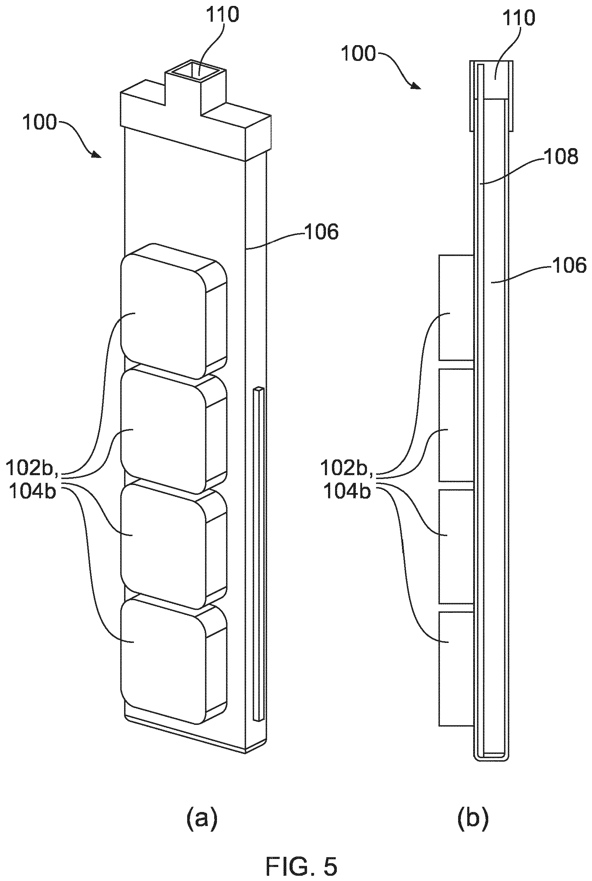

Figure 5 (a) and (b) show a more detailed illustration of a "hybrid" fluid electrodes arrangement, (a) a perspective front view and (b) a side view. Here, four equally dimensioned fluid electrodes 102b are axially spaced from one another along an axis parallel to the height of the fluid tank 4 (once inserted). It is understood that the space between the fluid electrodes can be equidistantly or of varying distance. Each one of the fluid electrodes 102b is adapted to detect a discrete fluid level when the fluid 7 reached into the operable range of a particular fluid electrode 102b, but, each one of the fluid electrodes 102b is also adapted to measure a continuous fluid level, for example, detected by a change in the capacitance measured for each one of these fluid electrodes 102b.

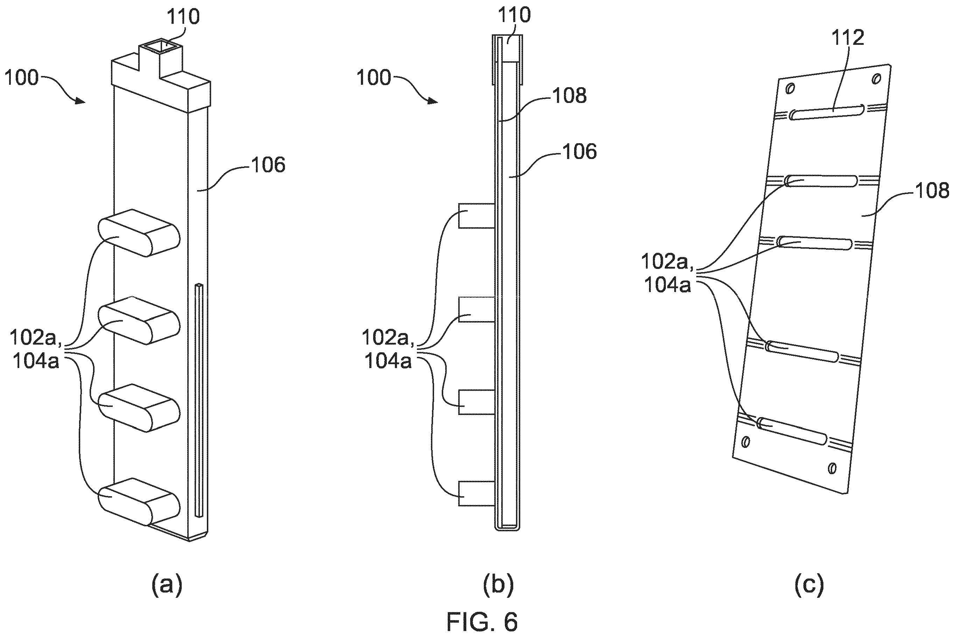

Figures 6 (a) to (c) show a more detailed illustration of a discrete fluid electrodes arrangement, (a) a perspective front view, (b) a side view and (c) a PCB 108 with the fluid electrode pads 102a incorporated for engagement with the resiliently deformable contact member 104a. Here, four equally dimensioned fluid electrodes 102a are axially spaced from one another along an axis parallel to the height of the fluid tank 4 (once inserted). The electrodes 102a can be spaced equidistantly or at varying distances between respective fluid electrodes 102a. Each one of the fluid electrodes 102a is adapted to only detect a discrete fluid level when the fluid 7 reaches a particular fluid electrode 102a, i.e. detecting a disturbance of the capacitance of that particular fluid electrode 102a. The electrode pads 102a on the PCB 108 are matched to fit with the resiliently deformable contact member 104a (footprint) (the same is true for any of the other embodiments, i.e. resiliently deformable contact members 104b, 104c). A reference or compensatory electrode 112 may also be provided for compensating any variations in the environmental parameters, such as, temperature or humidity etc.

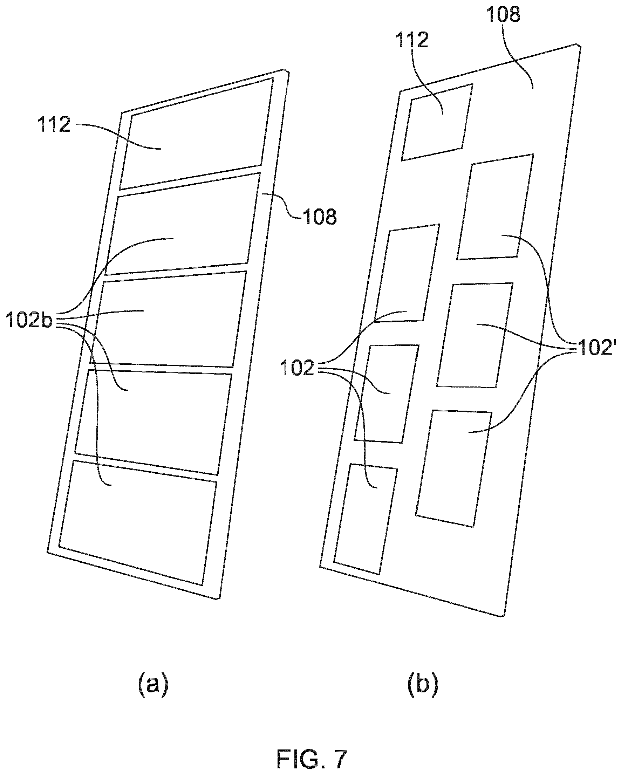

Figures 7(a) and (b) show another alternative example embodiments of an arrangement of fluid electrode pads 102 as positioned on the PCB 108. In particular, Figure 7(a) shows the layout of fluid electrode pads 102 for a "hybrid" fluid electrode arrangement, i.e. discrete fluid electrodes 102b that are also used to measure continues fluid level changes within each one of the fluid electrode ranges. A reference or compensatory electrode 112 is provided at the top of the PCB 108. Figure 7(b) shows a PCB layout of two parallelly arranged but axially offset rows of spaced apart fluid electrode pads 102, 102'. Again each one of the axially arranged fluid electrode pads 102, 102' is for a fluid electrode 102 configured to detect a discrete fluid level when a fluid 7 reaches the electric field of a fluid electrode 102, wherein each one of the fluid electrodes102 may also be used to detect continuous fluid changes within the range of each of the fluid electrodes 102.

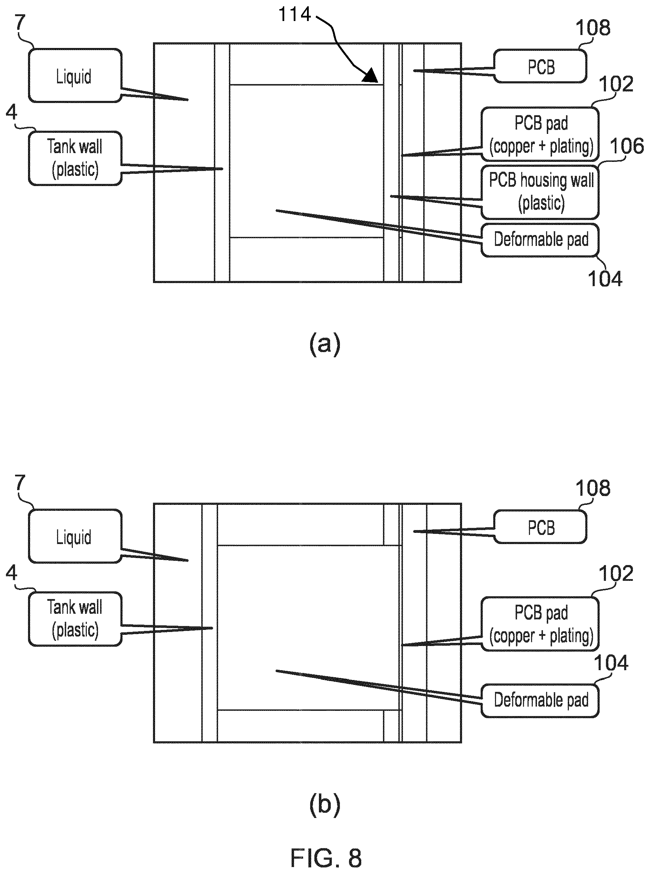

Referring now to Figures 8 (a), a cross-sectional side view is shown of a capacitive sensor assembly 100, where the resiliently deformable contact member 104 is attached to an outside surface of the housing 106 just overlaying the fluid electrode pad 102 of the PCB 108 ,as well as, in contact with the fluid tank 4. Figure 8 (b) shows an alternative version of the embodiment of Figure 8 (a), where the housing 106 comprises apertures 114 just overlaying the fluid electrode pads 102 of the PCB 108, so that the resiliently deformable contact member 104 is in direct contact with the fluid electrode pad 102 and the outside surface of the fluid tank 4.

The resiliently deformable contact member or pad 104 may be an insulator having a relative permittivity that is suitable to convey the electric field of the fluid electrode 102 of the capacitive sensor assembly 100 into the fluid tank 4. For example, the relative permittivity may be in the range of 2 to 20. Example materials may include a polymer, such as silicone or silicone rubber, a sponge material and the like.

On the other hand, the resiliently deformable contact member or pad 104 may be electrically conductive, so as to electrically extend the electrode pad 102 of the PCB 108 to the fluid tank 4. The resiliently deformable contact member or pad 104 may be made from a conductive polymer, such a silicone or silicone rubber compound mixed with conductive material (e.g. metal particles or filaments).

Alternatively, the resiliently deformable contact member or pad 104 may be made from a spring (not shown) made from a conductive metal. In these examples, the spring may be embedded within a polymer, for example rubber or silicone. In other examples, the spring may act between the housing 106 and the fluid electrode pads 102 of the PCB 108. In other examples, the deformable contact member or pad(s) 104 may comprise a spring in isolation, without any other material.

In other examples, the resiliently deformable contact member or pad(s) 104 may comprise a thermoplastic elastomeric material or may be made from a Graphene material or graphene rubber compound or a rubber or polymer comprising graphene or a graphene material such as graphene oxide, so as to make the compound electrically conductive.

It is understood by the person skilled in the art that any number and any suitable arrangement of fluid electrodes 9 may be provided so as to improve the resolution of fluid level detection, i.e. by providing more discrete levels of penetrating fields form the capacitive sensors. Further sensing electrodes may be provided to improve the resolution of fluid level detection. In both cases, fluid entering the electrical field will change (or disturb) a capacitance measured at a discrete electrode so as to determine a fluid level in the fluid tank 4. The capacitive sensor assembly 100 can be calibrated by measuring the detected capacitance (changes) for different fluid levels.

Throughout the description and claims of this specification, the words "comprise" and "contain" and variations of them mean "including but not limited to", and they are not intended to (and do not) exclude other moieties, additives, components, integers or steps.

## Claims

1. A capacitive sensor assembly (100) for detecting a fluid level within a removable tank (4) of a domestic appliance (1) along an axis (8), mountable within the domestic appliance, comprising a plurality of fluid level electrodes (102) spaced apart from one another along said axis, **characterised in that**, each one of said plurality of fluid level electrodes comprises a resiliently deformable contact member (104) adapted to contactingly engage with the removable tank (4) received in the domestic appliance and convey at least one electrical field generated by said capacitive sensor assembly (100) into the removable tank (4), wherein said resiliently deformable contact member (104) is made from an electrically conductive material adapted to convey said at least one electrical field generated by said capacitive sensor assembly into the removable tank (4).

2. A capacitive sensor assembly according to claim 1, wherein said resiliently deformable contact member is made from a material having a relative permittivity adapted to convey said at least one electrical field generated by said capacitive sensor assembly into the removable tank.

3. A capacitive sensor assembly according to any one of the preceding claims, wherein the removable tank is slidable in an insertion direction (8) through an opening (5) in the domestic appliance, and wherein the capacitive sensor assembly is mountable opposite to the opening such that said at least one resiliently deformable contact member is directed oppositely to the insertion direction so as to contactingly engage with a wall of the removable tank when inserted.

4. A capacitive sensor assembly according to any one of the preceding claims, wherein said resiliently deformable contact member matches the footprint of one of said plurality of fluid level electrodes.

5. A capacitive sensor assembly according to any one of claims 1 to 4, wherein said capacitive sensor assembly comprises a plurality of fluid level electrodes arranged so as to form a first row of spaced apart fluid level electrodes along said axis, and a second row of spaced apart fluid level electrodes along said axis parallel to and axially offset from said first row of said spaced apart fluid level electrodes.

6. The capacitive sensor according to any one of the preceding claims, wherein said capacitive sensor assembly comprises at least one reference electrode (112) configured for compensating variations in environmental parameters.

7. A capacitive sensor assembly of any one of the preceding claims, further comprising a housing (106) having an interior configured to receive a printed circuit board (PCB) (108) comprising contact pads operably coupleable with a respective one of said plurality of fluid level electrodes (102).

8. A capacitive sensor assembly according to claim 7, wherein said housing comprises a wall with said resiliently deformable contact members mounted to an outside surface of said wall, and wherein each one of said contact pads is operably coupled to said resiliently deformable contact member through said wall.

9. A capacitive sensor assembly according to claim 7, wherein said housing comprises a wall having at least one aperture (114), and wherein said resiliently deformable contact member is operably coupled to said contact pad through said aperture of said wall.

10. A capacitive sensor assembly according to any one of the preceding claims, wherein said resiliently deformable contact member comprises any one of:
- a sponge, for example an electrically conductive sponge,
- a silicone, for example an electrically conductive silicone,
- a rubber, for example an electrically conductive rubber, or
- a thermoplastic elastomer.

11. A capacitive sensor assembly according to any one of claims 1 to 9, wherein said resiliently deformable contact member comprises an electrically conductive spring member.

12. A capacitive sensor assembly according to claim 11, wherein said electrically conductive spring member is made from metal.

## Patentansprüche

1. Kapazitive Sensoranordnung (100) zum Erfassen eines Flüssigkeitspegels in einem entfernbaren Behälter (4) eines Haushaltsgeräts (1) entlang einer Achse (8), montierbar innerhalb des Haushaltsgeräts, umfassend eine Vielzahl von Flüssigkeitspegelelektroden (102), die entlang der Achse voneinander beabstandet sind, **dadurch gekennzeichnet, dass** jede der Vielzahl von Flüssigkeitspegelelektroden ein elastisch verformbares Kontaktelement (104) umfasst, das ausgestaltet ist, mit dem entfernbaren Behälter (4), der in dem Haushaltsgerät aufgenommen ist, unter Kontakt in Eingriff zu kommen und mindestens ein elektrisches Feld, das durch die kapazitive Sensoranordnung (100) erzeugt wird, in den entfernbaren Behälter (4) zu übertragen, wobei das elastisch verformbare Kontaktelement (104) aus einem elektrisch leitenden Material hergestellt ist, das ausgestaltet ist, das mindestens eine elektrische Feld, das durch die kapazitive Sensoranordnung erzeugt wird, in den entfernbaren Behälter (4) zu übertragen.

2. Kapazitive Sensoranordnung nach Anspruch 1, wobei das elastisch verformbare Kontaktelement aus einem Material mit einer relativen Dielektrizitätskonstante hergestellt ist, die ausgestaltet ist, das mindestens eine elektrische Feld, das durch die kapazitive Sensoranordnung erzeugt wird, in den entfernbaren Behälter zu übertragen.

3. Kapazitive Sensoranordnung nach einem der vorhergehenden Ansprüche, wobei der entfernbare Behälter in einer Einführrichtung (8) durch eine Öffnung (5) in dem Haushaltsgerät verschiebbar ist, und wobei die kapazitive Sensoranordnung gegenüber der Öffnung derart montierbar ist, dass das mindestens eine elastisch verformbare Kontaktelement entgegengesetzt zu der Einführrichtung gerichtet wird, um mit einer Wand des entfernbaren Behälters unter Kontakt in Eingriff zu kommen, wenn ein Einsetzen erfolgt.

4. Kapazitive Sensoranordnung nach einem der vorhergehenden Ansprüche, wobei das elastisch verformbare Kontaktelement der Grundfläche einer der Vielzahl von Flüssigkeitspegelelektroden entspricht.

5. Kapazitive Sensoranordnung nach einem der Ansprüche 1 bis 4, wobei die kapazitive Sensoranordnung eine Vielzahl von Flüssigkeitspegelelektroden aufweist, die derart angeordnet sind, dass sie eine erste Reihe von beabstandeten Flüssigkeitspegelelektroden entlang der Achse und eine zweite Reihe von beabstandeten Flüssigkeitspegelelektroden entlang der Achse parallel zu und axial versetzt von der ersten Reihe von beabstandeten Flüssigkeitspegelelektroden bilden.

6. Kapazitiver Sensor nach einem der vorhergehenden Ansprüche, wobei die kapazitive Sensoranordnung mindestens eine Referenzelektrode (112) aufweist, die zum Kompensieren von Änderungen in Umgebungsparametern eingerichtet ist.

7. Kapazitive Sensoranordnung nach einem der vorhergehenden Ansprüche, ferner umfassend ein Gehäuse (106) mit einem Innenbereich, der eingerichtet ist, eine Leiterplatte (108) aufzunehmen, die Kontaktflächen aufweist, die mit einer jeweiligen der Vielzahl von Flüssigkeitspegelelektroden (102) betriebsfähig koppelbar sind.

8. Kapazitive Sensoranordnung nach Anspruch 7, wobei das Gehäuse eine Wand mit den elastisch verformbaren Kontaktelementen, die an einer Außenfläche der Wand angebracht sind, aufweist, und wobei jede der Kontaktflächen betriebsfähig mit dem elastisch verformbaren Kontaktelement durch die Wand gekoppelt ist.

9. Kapazitive Sensoranordnung nach Anspruch 7, wobei das Gehäuse eine Wand mit mindestens einer Öffnung (114) aufweist, und wobei das elastisch verformbare Kontaktelement durch die Öffnung der Wand mit der Kontaktfläche betriebsfähig gekoppelt ist.

10. Kapazitive Sensoranordnung nach einem der vorhergehenden Ansprüche, wobei das elastisch verformbare Kontaktelement ein beliebiges der Folgenden aufweist:
- einen Schwamm, zum Beispiel einen elektrisch leitenden Schwamm,
- ein Silikon, zum Beispiel ein elektrisch leitendes Silikon,
- ein Gummi, zum Beispiel ein elektrisch leitender Gummi, oder
- ein thermoplastisches Elastomer.

11. Kapazitive Sensoranordnung nach einem der Ansprüche 1 bis 9, wobei das elastisch verformbare Kontaktelement ein elektrisch leitendes Federelement aufweist.

12. Kapazitive Sensoranordnung nach Anspruch 11, wobei das elektrisch leitende Federelement aus Metall hergestellt ist.

## Revendications

1. Ensemble capteur capacitif (100) pour la détection d'un niveau de fluide au sein d'un réservoir amovible (4) d'un appareil ménager (1) le long d'un axe (8), montable au sein de l'appareil ménager, comprenant une pluralité d'électrodes de niveau de fluide (102) espacées les unes des autres le long dudit axe, **caractérisé en ce que**, chacune de ladite pluralité d'électrodes de niveau de fluide comprend un organe de contact déformable de manière élastique (104) adapté pour venir en prise par contact avec le réservoir amovible (4) reçu dans l'appareil ménager et transporter au moins un champ électrique généré par ledit ensemble capteur capacitif (100) jusque dans le réservoir amovible (4), dans lequel ledit organe de contact déformable de manière élastique (104) est composé d'un matériau électroconducteur adapté pour transporter ledit au moins un champ électrique généré par ledit ensemble capteur capacitif jusque dans le réservoir amovible (4).

2. Ensemble capteur capacitif selon la revendication 1, dans lequel ledit organe de contact déformable de manière élastique est composé d'un matériau ayant une constante diélectrique adaptée pour transporter ledit au moins un champ électrique généré par ledit ensemble capteur capacitif jusque dans le réservoir amovible.

3. Ensemble capteur capacitif selon l'une quelconque des revendications précédentes, dans lequel le réservoir amovible peut coulisser dans une direction d'insertion (8) à travers une ouverture (5) dans l'appareil ménager, et dans lequel l'ensemble capteur capacitif peut être monté à l'opposé de l'ouverture de telle sorte que ledit au moins un organe de contact déformable de manière élastique est dirigé à l'opposé de la direction d'insertion de manière à venir en prise par contact avec une paroi du réservoir amovible lorsqu'il est inséré.

4. Ensemble capteur capacitif selon l'une quelconque des revendications précédentes, dans lequel ledit organe de contact déformable de manière élastique concorde avec l'empreinte de l'une de ladite pluralité d'électrodes de niveau de fluide.

5. Ensemble capteur capacitif selon l'une quelconque des revendications 1 à 4, dans lequel ledit ensemble capteur capacitif comprend une pluralité d'électrodes de niveau de fluide agencées de manière à former une première rangée d'électrodes de niveau de fluide espacées le long dudit axe, et une deuxième rangée d'électrodes de niveau de fluide espacées le long dudit axe parallèlement à ladite première rangée desdites électrodes de niveau de fluide espacées et décalée axialement par rapport à celle-ci.

6. Capteur capacitif selon l'une quelconque des revendications précédentes, dans lequel ledit ensemble capteur capacitif comprend au moins une électrode de référence (112) configurée pour compenser les variations des paramètres environnementaux.

7. Ensemble capteur capacitif selon l'une quelconque des revendications précédentes, comprenant en outre un logement (106) ayant un intérieur configuré pour recevoir une carte de circuit imprimé (PCB) (108) comprenant des plots de contact pouvant être couplés de manière fonctionnelle à l'une respective de ladite pluralité d'électrodes de niveau de fluide (102).

8. Ensemble capteur capacitif selon la revendication 7, dans lequel ledit logement comprend une paroi avec lesdits organes de contact déformable de manière élastiques montés sur une surface extérieure de ladite paroi, et dans lequel chacun desdits plots de contact est couplé de manière fonctionnelle audit organe de contact déformable de manière élastique à travers ladite paroi.

9. Ensemble capteur capacitif selon la revendication 7, dans lequel ledit logement comprend une paroi ayant au moins un orifice (114), et dans lequel ledit organe de contact déformable de manière élastique est couplé de manière fonctionnelle audit plot de contact à travers ledit orifice de ladite paroi.

10. Ensemble capteur capacitif selon l'une quelconque des revendications précédentes, dans lequel ledit organe de contact déformable de manière élastique comprend l'un quelconque parmi :
- une éponge, par exemple une éponge électroconductrice,
- une silicone, par exemple une silicone électroconductrice,
- un caoutchouc, par exemple un caoutchouc électroconducteur, ou
- un élastomère thermoplastique.

11. Ensemble capteur capacitif selon l'une quelconque des revendications 1 à 9, dans lequel ledit organe de contact déformable de manière élastique comprend un organe ressort électroconducteur.

12. Ensemble capteur capacitif selon la revendication 11, dans lequel ledit organe ressort électroconducteur est composé de métal.
